(19) Europäisches Patentamt
European Patent Office
Office européen des brevets

(11) **EP 2 487 499 B1**

(12) **EUROPÄISCHE PATENTSCHRIFT**

(45) Veröffentlichungstag und Bekanntmachung des Hinweises auf die Patenterteilung:
**18.07.2018  Patentblatt 2018/29**

(51) Int Cl.:
*H01M 10/42* *(2006.01)*  *G01R 31/36* *(2006.01)*
*G06F 17/50* *(2006.01)*

(21) Anmeldenummer: **11185161.4**

(22) Anmeldetag: **14.10.2011**

(54) **Echtzeitfähige Batteriezellensimulation**

Real-time-capable battery cells simulation

Temps réel capable simulation de pile à batterie

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.12.2010  DE 102010062838**

(43) Veröffentlichungstag der Anmeldung:
**15.08.2012  Patentblatt 2012/33**

(73) Patentinhaber: **dSPACE digital signal processing and control engineering GmbH 33102 Paderborn (DE)**

(72) Erfinder:
• **Haupt, Hagen 33184 Altenbeken (DE)**
• **Schulte, Thomas 33813 Oerlinghausen (DE)**
• **Vollbrecht, Christian 77715 Brühl (DE)**

(56) Entgegenhaltungen:
**AT-U2- 10 763     DE-U1-202010 010 492**

• **"Spannung garantiert, Hochgenaue Zellspannungssimumlation mit dem dSPACE HIL-Simulator", dSPACE Magazin 3/2010, 31. Dezember 2010 (2010-12-31), Seiten 40-45, XP002679139, Gefunden im Internet: URL:http://www.dspace.com/shared/data/pdf/ 2011/dSPACE-Magazine-2010-03_Batterie_D.pd f [gefunden am 2012-06-27]**
• **YONGJUN YUAN ET AL: "Assessment of power consumption control strategy for battery management system using hardware-in-the-loop simulation", VEHICLE POWER AND PROPULSION CONFERENCE, 2008. VPPC '08. IEEE, IEEE, PISCATAWAY, NJ, USA, 3. September 2008 (2008-09-03), Seiten 1-6, XP031363165, DOI: 10.1109/VPPC.2008.4677485 ISBN: 978-1-4244-1848-0**

**Beschreibung**

Die Erfindung betrifft ein Verfahren zur Simulation von Batteriezellen zum Testen eines Steuergerätes und ein System zur Simulation einer einen Zellenverbund aus mehreren Einzelzellen umfassenden Batterie.

Eine weitverbreitete Technologie zum frühen Testen und Verifizieren der Funktionsfähigkeit von Steuergeräten, z.B. im automotiven Bereich, ist die Hardware-in-the-Loop (HIL). Hierbei werden reale Steuergeräte in Wechselwirkung mit in Echtzeit simulierten Komponenten darauf getestet, in wie weit sie den spezifizierten Anforderungen genügen. Die Umgebung des zu testenden Steuergerätes, bestehend aus Aktoren, Sensoren und den Prozessen im Fahrzeug wird in Echtzeit simuliert und das Verhalten des Steuergerätes in dieser simulierten Umgebung untersucht.

Die HIL-Simulation erlaubt, Steuergeräte in einem frühen Entwicklungsstadium zu Testen und ihr Verhalten zum Beispiel bei Sensorfehlern zu prüfen. Sollen nun Steuergeräte in Hybridfahrzeugen mittels HIL-Simulation getestet werden, besteht die Notwendigkeit, die Batterien als eine Systemkomponente zu simulieren. In Hybridfahrzeugen werden Batterien aus vielen Einzelzellen eingesetzt. Insbesondere werden auch Steuergeräte für die Batterie-Kontrolle, sogenannte Batterie-Management-Systeme (BMS), durch HIL-Simulationen getestet. BMS haben die Aufgabe, die Zellen in einem Zellenverbund zu überwachen und damit einen sicheren, zuverlässigen und möglichst langen Betrieb des Zellenverbundes sicherzustellen. Zum Testen des BMS durch HIL-Simulation muss das Verhalten eines Zellverbundes simuliert werden. Aus diesen Gründen werden sowohl Modelle zur Simulation einzelner Zellen als auch großer Zellenverbunde benötigt.

Im Vergleich zu herkömmlichen Batteriemodellen, wie sie für die Bordnetzsimulation eingesetzt werden, müssen Modelle für Batteriemanagementsysteme das Verhalten der Batterie als Zusammenschaltung mehrerer Einzelzellen nachbilden. Ein Einzelzellenmodell bildet dabei Zellenspannung und Ladungszustand und eventuell auch das Temperaturverhalten einer Batteriezelle ab. Typisches Zellenverhalten unterschiedlicher Zelltechnologien wie Li-Ionen, Ni-MH oder Blei kann berücksichtigt werden. Dazu gehören Unterschiede beim Laden und Entladen, sowie das dynamische Verhalten bei Belastungssprüngen und Verlustströmen zum Beispiel durch Gasungseffekte. Das Modell der Batterie setzt sich dann üblicherweise aus mehreren Einzelzellenmodellen zusammen.

Einzelne Zellenparameter und -zustände wie Innenwiderstand oder initialer Ladezustand müssen dabei individuell einstellbar bleiben und die resultierenden Zellenspannungen müssen dem BMS auch einzeln zur Verfügung gestellt werden können, beispielsweise durch einen Zellspannungsemulator. Die dann vom BMS eingestellten Ströme zum Ladungsausgleich der Zellen sind ebenfalls zu berücksichtigen.

Im Rahmen von HIL-Anwendungen im Bereich von Hybridfahrzeugen, Elektrofahrzeugen oder auch BMS ist vor allem das elektrische Klemmenverhalten der Batterie von Interesse.

Zur Modellierung des elektrischen Klemmenverhaltens der Zellen wird häufig der Ansatz gewählt, das Klemmenverhalten durch äquivalente elektrische Ersatzschaltbilder zu beschreiben. Dies bildet einen guten Kompromiss zwischen der Komplexität der elektrochemischen Vorgänge in einer Zelle auf der einen Seite und notwendigen Vereinfachungen, zum Beispiel zur Sicherstellung der Echtzeitfähigkeit des Zellmodells auf der anderen Seite. Ein weiterer Vorteil der Modellierung von Batteriezellen mittels äquivalenter elektrischer Ersatzschaltbilder ist die Möglichkeit, bei Simulationen mit einem Schaltungssimulator die betrachtete Anordnung um weitere Komponenten wie Stromrichter zu erweitern.

Einzelzellenmodelle für automotive Simulationsmodelle, wie sie beispielsweise von der Anmelderin vertrieben werden, setzen sich aus einem Zellenspannungsmodell und einem Modell für den Ladungszustand zusammen. Das Zellenspannungsmodell ermöglicht, die Parametrierung einzelner physikalischer Effekte wie Innenwiderstand, Diffusion und Doppelschichtkapazität. Das Ladungszustandsmodell berücksichtigt sowohl den Lade- und Entladestrom der Einzelzelle als auch Verlustströme, wie sie beispielsweise durch Gasungseffekte beim Laden von Ni-MH-Zellen entstehen. Ausgehend von einem solchen Einzelzellenmodell kann ein Zellenverbund aus n Zellen durch die Zusammenschaltung von n Einzelzellenmodellen erfolgen. Bei einer großen Anzahl von Einzelzellen ist so ein Modell allerdings nicht mehr gut handhabbar und ab einer bestimmten Anzahl von Einzelzellen nicht mehr echtzeitfähig. Das bedeutet, dass selbst mit für HIL-Simulationen spezialisierter Hardware die Anforderungen an die Laufzeit der Modelle nicht mehr eingehalten werden können. Somit kann der Test eines Steuergerätes, der z.B. auch die Reaktionszeit des Steuergerätes prüfen muss, nicht unter Bedingungen durchgeführt werden, die die Realität widerspiegeln.

Die Möglichkeit, nur eine einzige Einzelzelle zu simulieren und die Ausgangsgrößen durch Multiplikation mit der Zellenanzahl n zu skalieren, ist für den Test von BMS nicht durchführbar, da in diesem Fall Parameterstreuungen und unterschiedliche Ladungszustände der Einzelzellen nicht mehr abgebildet werden können.

Die Aufgabe der vorliegenden Erfindung ist daher, ein Verfahren bereitzustellen, das die Nachteile des Standes der Technik verringert.

Die Aufgabe wird gelöst durch ein Verfahren gemäß dem ersten unabhängigen Anspruch und durch ein System zur Simulation einer einen Zellenverbund aus mehreren Einzelzellen umfassenden Batterie gemäß dem Anspruch 12.

Erfindungsgemäß wird ein Verfahren bereitgestellt zur Echtzeit-Simulation einer einen Zellenverbund aus mehreren Einzelzellen umfassenden Batterie durch ein Gesamtmodell auf einer Recheneinheit, wobei die Recheneinheit über einen Zellspannungsemulator mit einem Steuergerätesystem verbunden ist. Mittels des Gesamtmodells werden die Klemmspannungen der Einzelzellen auf der Recheneinheit berechnet und mittels des Zellspannungsemulators werden dem Steuergerätetestsystem die berechneten Klemmspannungen der Einzelzellen zur Verfügung gestellt. Das Gesamtmodell umfasst ein erstes Modell (auch Referenzmodell genannt), wobei mittels des ersten Modells eine erste Einzelzelle als Referenzzelle mit für den Zellenverbund typischen Zellenparametern modelliert wird. Als Eingangsgröße wird dem ersten Modell der Gesamteingangsstrom des Zellenverbundes zugeführt und mittels des ersten Modells die Klemmspannung der Referenzzelle berechnet. Weiterhin umfasst das Gesamtmodell ein zweites Modell (auch Differenzenmodell genannt), wobei mittels des zweiten Modells eine Abweichung der Klemmspannung mindestens einer weiteren Einzelzelle von der Klemmspannung der Referenzzelle berechnet wird. Die Klemmspannung der weiteren Einzelzelle wird aus der Klemmspannung der Referenzzelle und der Abweichung der Klemmspannung der weiteren Einzelzelle berechnet.

Die Klemmspannungen der gesamten Batterie sowie der Einzelzellen und/oder der Ladungszustand der Batterie und der Einzelzellen und/oder die Batterietemperatur werden als Funktion des Lade- und Entladestroms der Batterie, d.h. des Gesamtstroms, berechnet.

In einer vorteilhaften Ausgestaltung der Erfindung wird mittels des zweiten Modells die Abweichung der Klemmspannung jeder weiteren Einzelzelle von der Klemmspannung der Referenzzelle berechnet. Aus der Klemmspannung der Referenzzelle und der berechneten Abweichung kann die jeweilige Klemmspannung jeder weiteren Einzelzelle berechnet werden.

Ein Vorteil des erfindungsgemäßen Verfahrens ist es, dass der Rechenaufwand für die Berechnung aller relevanten Größen der Referenzzelle und der weiteren Einzelzellen mittels des erfindungsgemäßen Verfahrens gegenüber der Berechnung besagter Größen mittels n Einzelzellenmodellen stark reduziert ist. Somit wird eine Echtzeitsimulation für eine Batterie mit einer deutlich höheren Anzahl an Einzelzellen ermöglicht. Auch der Speicherverbrauch wird optimiert.

Vorzugsweise wird dem Differenzenmodell mindestens eine Größe bzw. ein Parameter, wie etwa die Zellentemperatur, der ohmsche Widerstand $R_{innen}$ oder der Ladezustand, von der Referenzzelle zugeführt. Mindestens eine der Größen mindestens einer weiteren Einzelzelle wie der Anfangsladezustand, die Nennkapazität $C_{Nenn}$ - d.h. die Ladung, die an einer neuen Zelle unter Nennbedingungen bestimmbar ist - und die Abweichung von Widerstand, Temperatur und/oder Klemmenstrom wird dem Differenzenmodell vorgegeben. In Abhängigkeit der vorgegebenen Größen wird die Klemmspannungsabweichung errechnet.

Mit Größen sind hier allgemein Eigenschaften einer Einzelzelle oder des Zellenverbundes gemeint, wie z.B. der Ladezustand einer Einzelzelle. Insbesondere sind berechnete oder zu berechnende Größen, also Simulationsgrößen oder -variablen gemeint.

Mit Parametern oder Zellenparametern sind hier ebenfalls Größen gemeint, insbesondere vorgegebene physikalische Größen, die beispielsweise eine physikalische Eigenschaft oder einen physikalischen Zustand einer Einzelzelle charakterisieren.

Die Verringerung der Rechenzeit ergibt sich unter anderem dadurch, dass Größen, wie zum Beispiel die Zellentemperatur, nicht für jede Einzelzelle gesondert simuliert werden, sondern aus der Simulation der Referenzzelle und der vorgegebenen Temperaturabweichung jeder Einzelzelle bezüglich der Referenzzelle bestimmt werden. Dadurch wird Rechenzeit eingespart. Die Verringerung der Rechenzeit ist nötig, um in Echtzeit simulieren bzw. gewährleisten zu können, dass das Modell rechtzeitig auf Signale des zu testenden Steuergerätes reagiert und dem Steuergerät mittels des Zellspannungsemulators eine realitätsnahe Reaktion vorgetäuscht wird.

Besonders vorteilhaft ist die Vorgabe von Eingangsgrößen für das Differenzenmodell in Form von Vektoren, z.B. nx1-Vektoren, wobei n die Anzahl der betrachteten weiteren Zellen ist. Dadurch wird die Komplexität des Differenzenmodells unabhängig von der Anzahl der zu berücksichtigenden Zellen. Es ist somit nur ein zweites Modell für n weitere Einzelzellen notwendig. Die Anzahl der betrachteten weiteren Einzelzellen ergibt sich aus der Breite der vorgegebenen Vektoren.

Es gibt verschiedene Möglichkeiten, das Differenzenmodell in Teilmodelle aufzuteilen.

In einer bevorzugten Ausführungsform umfasst das Differenzenmodell zwei Teilmodelle.

In einem ersten Teilmodell werden die Abweichungen berücksichtigt, die zu einer im Vergleich zur Referenzzelle unterschiedlichen elektromotorischen Kraft (EMK) führen, während in einem zweiten Teilmodell die Abweichungen betrachtet werden, die Unterschiede in den Überspannungen zur Folge haben.

Mit der EMK ist hier die Spannungsdifferenz zwischen den beiden Elektroden in einer elektrochemischen Zelle im Ruhezustand gemeint.

Als Überspannung wird die Differenz zwischen der Klemmspannung und der EMK bezeichnet, die zum Beispiel beim Laden oder Entladen auftritt. Die Überspannung fällt über dem ohmschen Widerstand der Zelle ab, bzw. an allen passiven Bauelementen des Ersatzschaltbildes der Zelle.

Mit dem Übergang der Modellbeschreibung von der Batterieebene auf die Zellenebene steigen auch die Anforderungen an die Parametrierung. Bevorzugt werden benutzerfreundliche Eingabeoberflächen angebunden.

Das erfindungsgemäße System zur Simulation einer einen Zellenverbund aus mehreren Einzelzellen umfassenden Batterie mittels eines Gesamtmodells weist eine Recheneinheit und einen mit der Recheneinheit verbundenen Zellspannungsemulator auf, wobei die Recheneinheit eingerichtet ist, das Gesamtmodell zur Berechnung der Klemmspannungen der Einzelzellen auszuführen und wobei der Zellspannungsemulator ausgebildet ist, mit einem Steuergerätesystem verbunden zu werden und dem Steuergerätetestsystem die berechneten Klemmspannungen der Einzelzellen zur Verfügung zu stellen. Erfindungsgemäß umfasst das Gesamtmodell ein erstes Modell und ein zweites Modell. Das erste Modell ist eingerichtet, eine erste Einzelzelle als Referenzzelle mit typischen Zellenparametern zu modellieren, den Gesamteingangsstrom des Zellenverbundes als Eingangsgröße zu erhalten und die Klemmspannung der Referenzzelle zu berechnen. Das zweite Modell ist eingerichtet, die Abweichung der Klemmspannung mindestens einer weiteren Einzelzelle von der Klemmspannung der Referenzzelle zu berechnen und die Klemmspannungen der weiteren Einzelzelle aus der Abweichung und der Klemmspannung der Referenzzelle zu berechnen.

Das erfindungsgemäße System und Verfahren zur Simulation von Batteriezellen zum Testen eines Steuergerätes soll nachfolgend anhand der Ausführungsbeispiele im Zusammenhang mit den schematisierten Zeichnungen erläutert werden. Hierbei sind funktionsgleiche Schaltungsteile mit denselben Bezugszeichen versehen.

Es zeigen, die

Abbildung 1: ein äquivalentes elektrisches Ersatzschaltbild einer elektrochemischen Zelle,

Abbildung 2: einen schematischen EMK-SOC-Zusammenhang für eine Li-Ionen-Zelle,

Abbildung 3: die Struktur eines erfindungsgemäßen Gesamtmodells,

Abbildung 4: die Struktur des Differenzenmodells mit einem ersten Teilmodell und einem zweiten Teilmodell.

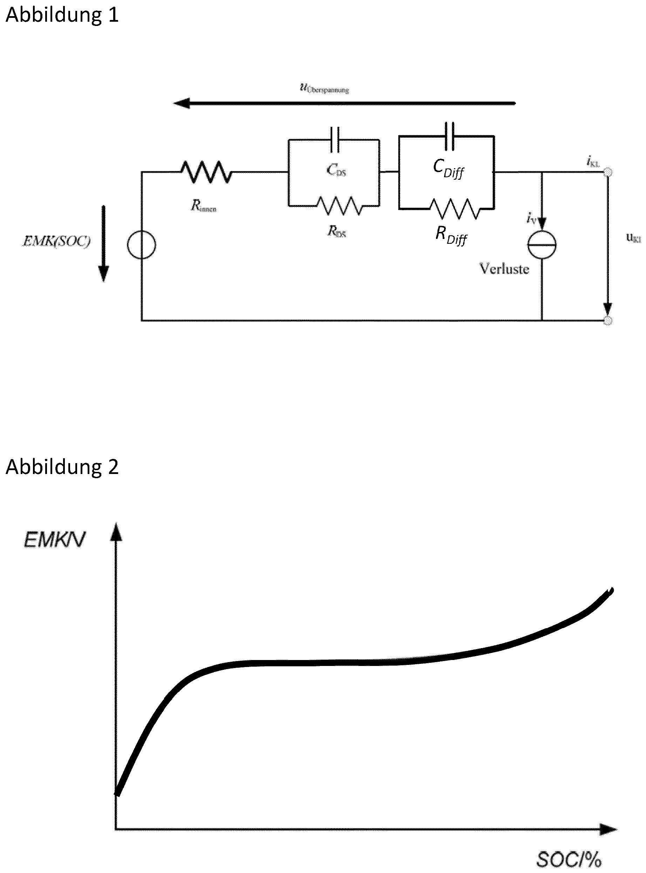

Die Abb. 1 zeigt das äquivalente Ersatzschaltbild für eine elektrochemische Zelle, wie sie im Stand der Technik als Grundlage für das Modell einer einzelnen Batteriezelle dient. Mit Hilfe dieses Ersatzschaltbildes wird die Klemmspannung der Zelle berechnet. Es wird darauf hingewiesen, dass das erfindungsgemäße Verfahren unabhängig von der gewählten Parametrierung ist, für die es verschiedene Durchführungsmöglichkeiten gibt. Auch können prinzipiell andere Modelle für die Modellierung verwendet werden, die auf einer anderen Ersatzschaltung basieren.

Abbildung 1 zeigt zum einen die an den Klemmen einer Zelle messbaren Größen der Klemmspannung $u_{Kl}$ und des Klemmenstromes $i_{Kl}$, wobei hier noch erwähnt sei, dass ein positiver Klemmenstrom dem Laden der Zelle und ein negativer Klemmenstrom dem Entladen der Zelle entspricht.

Des Weiteren umfasst das Ersatzschaltbild eine Spannungsquelle mit einer als EMK bezeichneten Spannung. Damit wird die Elektromotorische Kraft (EMK) einer Zelle beschrieben. Ein weiterer wichtiger Aspekt im Ersatzschaltbild in Abb. 1 ist das Netzwerk aus passiven Bauelementen zur Beschreibung der Überspannungen in der Zelle. Beim Laden fällt an den Klemmen der Zelle eine höhere Spannung ab als zwischen den beiden Elektroden der Zelle, beim Entladen ist die Klemmspannung wiederum niedriger als die Spannung zwischen den beiden Elektroden. Diese Anteile der Klemmspannung werden durch das Netzwerk aus passiven Bauelementen modelliert. Die in Abb. 1 zu erkennende Stromquelle mit dem Strom $i_V$ modelliert die in einer elektrochemischen Zelle auftretenden Verlustströme.

Das Potential einer Elektrode ergibt sich aus dem Standard-Redox-Potential der jeweiligen Elektrode und einem Anteil, der nach der Nernst'schen Gleichung von der Aktivität der reduzierten und oxidierten Spezies und damit von deren Konzentration abhängt.

Bei Lithium-Ionen Zellen tritt beispielsweise zudem der Effekt auf, dass sich je nach verwendetem Elektrodenmaterial die Gitterstruktur, in die die Lithium-Atome eingelagert werden, ab einer gewissen Menge an eingelagertem Lithium verändert, was ebenfalls zu Änderungen des Elektrodenpotentials führt. Je nach Ladezustand der Zelle befindet sich in der einen oder anderen Elektrode eine größere Menge an eingelagertem Lithium. Diese Menge an eingelagertem Lithium hat dann Einfluss auf das Potential der Elektrode, einmal über die Abhängigkeit der Gitterstruktur von der Lithiummenge, zum anderen aber auch über die Aktivität des oxidierten oder reduzierten Lithiums, die direkt von der Konzentration des Lithiums abhängt. Solche materialspezifischen Effekte können in das Batteriemodell aufgenommen werden, je nachdem, welche Technologie beschrieben werden soll.

Die Potentiale der Elektroden einer elektrochemischen Zelle und damit auch die Elektromotorische Kraft einer Zelle sind daher abhängig vom Ladezustand (SOC) der Zelle.

Der Ladezustand einer Zelle wird als State of Charge (SOC) bezeichnet und in Prozent angegeben. Der SOC ergibt sich aus der Ladung einer Zelle, bezogen auf die Nennkapazität der Zelle. Eine voll geladene Zelle hat somit einen SOC von 100%, eine voll entladene Zelle einen SOC von 0%.

Abbildung 2 zeigt den EMK-SOC-Zusammenhang, der einen monoton steigenden Verlauf aufweist. Die maximale EMK wird demnach bei einem SOC=100% erreicht. Wird dann der Ladezustand der Zelle verringert, ist zunächst ein etwas stärkeres Absinken der EMK festzustellen. Danach ist ein Bereich auszumachen, in dem sich die EMK nur geringfügig ändert, um dann bei niedrigem Ladezustand der Zelle stark abzufallen. Je nach verwendeten Materialien für die Elektroden kann es bezüglich des Verlaufs zu gewissen Variationen, zum Beispiel hinsichtlich der Ausprägung des mittleren Bereiches kommen. Diese Abhängigkeit wird mittels eines äquivalenten elektrischen Ersatzschaltbilds aus Abb. 1 durch die gesteuerte Spannungsquelle EMK(SOC) modelliert.

Im Stand der Technik wird teilweise ein formelhafter Zusammenhang für die Abhängigkeit der EMK vom SOC verwendet, teilweise wird der Zusammenhang über gesteuerte Spannungsquellen und in Kennfeldern hinterlegte Daten oder eine Approximation des EMK-SOC-Zusammenhangs modelliert. Zur Approximation des EMK-SOC-Zusammenhangs werden verschiedene Verfahren verwendet. Beispielsweise die lineare Interpolationsmethode, die lineare Extrapolationsmethode oder auch Mischformen daraus.

Der aktuelle Ladezustand der Zelle wird durch Integration des wirksamen Lade- oder Entlade-Stromes bestimmt.

$$SOC = SOC_0 + \frac{1}{C_{\mathrm{Nenn}}} \int i_{\mathrm{Kl}} - i_{\mathrm{V}}\, dt$$

(Gleichung 1)

Der Widerstand $R_{\mathrm{innen}}$ im elektrischen Ersatzschaltbild beschreibt den ohmschen Widerstand der elektrochemischen Zelle. Dieser Innenwiderstand setzt sich zusammen aus dem Widerstand der Elektrodenmaterialien und dem Widerstand des Elektrolyten.

Es kann vorkommen, dass je nach verwendetem Material der Widerstand der Elektroden vom Ladezustand abhängig ist. Es ist also möglich, dass der Widerstand $R_{\mathrm{innen}}$ vom SOC abhängig ist.

Ein weiterer wichtiger Aspekt bezüglich des Widerstands $R_{\mathrm{innen}}$ ist dessen Abhängigkeit von der Temperatur. Die Temperaturabhängigkeit resultiert hauptsächlich aus dem Widerstandsanteil des Elektrolyten, der von der Temperatur abhängt. In der Literatur sind hinsichtlich des Innenwiderstands elektrochemischer Zellen unterschiedliche Ansätze festzustellen. So wird im Ersatzschaltbild der Innenwiderstand entweder als konstant, als von der Temperatur abhängig oder als abhängig vom SOC angesetzt. Zur Beschreibung solcher Abhängigkeiten kann eine Erweiterung der Parameter-Kennfelder vorgesehen sein. Eine Erweiterung des Modells ist nicht erforderlich. Es kann jedoch auch eine Stromabhängigkeit des Innenwiederstands berücksichtigt werden.

Das im elektrischen Ersatzschaltbild in Abb. 1 zu erkennende RC-Glied, bestehend aus dem Widerstand $R_{\mathrm{DS}}$ und der Kapazität $C_{\mathrm{DS}}$, dient dazu, die dynamischen Verläufe der Überspannungen zu berücksichtigen.

Diese dynamischen Verläufe lassen sich auf Vorgänge an der Grenze zwischen der Elektrode und dem Elektrolyten zurückführen.

Die sich gegenüberstehenden Ladungen unterschiedlicher Polarisation mit der Schicht ausgerichteter Elektrolytdipole als Dielektrikum bilden eine sogenannte Doppelschicht- Kapazität, die aufgrund des geringen Abstandes zwischen den beiden Ladungsschichten und der großen Elektrodenoberfläche, die sich aus der Porosität des Elektrodenmaterials ergibt, nicht vernachlässigt werden kann. Aufgrund dieser Doppelschichtkapazität ist im elektrischen Ersatzschaltbild die Kapazität $C_{\mathrm{DS}}$ eingefügt.

Das dem Zellenmodell zugrundeliegende Ersatzschaltbild kann noch um ein zusätzliches RC-Glied ($R_{\mathrm{Diff}}$, $C_{\mathrm{Diff}}$) erweitert werden, um die Berücksichtigung dynamischer Überspannungsanteile mit einer größeren Zeitkonstanten zu ermöglichen.

Die Spannungsanteile mit einer größeren Zeitkonstanten lassen sich auf Diffusionsvorgänge im Elektrolyten zurückführen. Diffusionsvorgänge können alternativ aber auch mittels eines Diffusionsschichtmodells berücksichtigt werden.

Die in einer elektrochemischen Zelle auftretenden Verluste werden in dem äquivalenten Ersatzschaltbild durch eine Stromquelle berücksichtigt. Der auftretende Verluststrom $i_{\mathrm{V}}$ hat zur Folge, dass bei der Ladung der Zelle nicht der gesamte Klemmenstrom zur Erhöhung der in der Zelle gespeicherten Energie beiträgt, und bei der Entladung, dass nicht die gesamte Energie, die aus der chemischen in die elektrische Form umgewandelt wird, an den Klemmen der Zelle entnommen werden kann. Der Verluststrom $i_{\mathrm{V}}$ der Zelle ist dabei abhängig von der Zellenklemmspannung und der Temperatur. Eine Berücksichtigung des Verluststroms ist nicht für alle Zelltechnologien relevant.

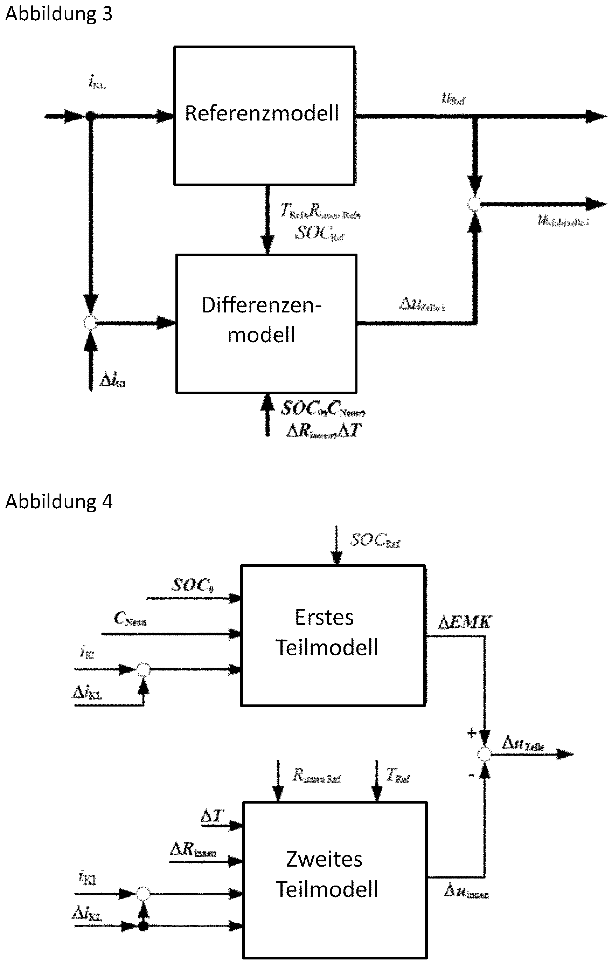

Abbildung 3 zeigt ein erfindungsgemäßes Gesamtmodell für eine mehrere (n+1) Einzelzellen umfassende Batterie.

Das Referenzmodell ist durch ein Einzelzellenmodell gegeben, wie es aus dem Stand der Technik bekannt ist. Es erhält den Eingangsstrom des Zellenverbunds, d.h. den Lade- bzw. Entladestrom der Batterie, als Eingangsgröße, wobei dieser in der Regel in einem weiteren Simulationsmodell berechnet wird. Mittels des Referenzmodells wird das Verhalten einer ersten Einzelzelle im Zellenverbund simuliert. Die erste Einzelzelle weist bezüglich der Zellenparameter und des Ladezustands die Referenzwerte des zu simulierenden Zellenverbundes auf. Referenzwerte für die Zellen im Verbund sind aus den entsprechenden Datenblättern der Batterie zu entnehmen oder aus Messungen an einer Einzelzelle zu bestimmen, für typische Zellenparameter wie Kapazität oder Innenwiderstand.

Einen zweiten Teil des Gesamtmodells bildet ein zweites Modell, das Differenzenmodell. In diesem zweiten Modell wird die Abweichung der Klemmspannung der i-ten weiteren Einzelzelle von der Klemmspannung der Referenzzelle $\Delta u_{\text{Zell i}}$ berechnet. Eine Abweichung der Klemmspannung einer weiteren Einzelzelle von der Klemmspannung der Referenzzelle kann sich aus Abweichungen der Zellenparameter der weiteren Einzelzelle wie Innenwiderstand oder Kapazität, einem anderen Ladezustand, einer anderen Zellentemperatur oder Abweichungen in den Klemmenströmen ergeben. Solche Abweichungen in den Klemmenströmen treten beispielsweise dadurch auf, dass das BMS zum Ladungsausgleich der Zellen (das sogenannte "Cell balancing") unterschiedliche Ströme für die jeweiligen weiteren Einzelzellen vorgibt. Durch das zweite Modell werden also die Abweichungen weiterer Einzelzellen des Zellenverbundes von der Referenzzelle berücksichtigt. Daher wird dieses Modell auch als Differenzenmodell bezeichnet. Das Differenzenmodell erhält während der Simulation veränderbare Eingangsgrößen wie den Klemmenstrom, d.h. den Gesamtstrom, und die Abweichung des Klemmenstroms für jede weitere Einzelzelle, die Zellentemperatur, den ohmschen Widerstand $R_{\text{innen}}$ oder den Ladezustand der Referenzzelle. Bevorzugt wird mindestens einer der folgenden Parameter dem Differenzenmodell vorgegeben: der Anfangsladezustand, die Nennkapazität und die Abweichungen von Widerstand und/oder Temperatur der jeweiligen weiteren Einzelzellen. In Abhängigkeit der Parameter und der Simulationsgrößen wird die Abweichung der Klemmspannung für die weiteren Einzelzellen errechnet. Aus der Klemmspannung der Referenzzelle und der Abweichung bezüglich der i-ten Zelle wird die Klemmspannung dieser i-ten Zelle bestimmt.

In einer bevorzugten Ausführungsform erhält das Differenzenmodell die Abweichungen des Klemmenstroms als veränderbare Eingangsgröße und die vorgegebenen Parameter in vektorieller Form, z.B. als n x 1-Vektor.

In einer weiteren bevorzugten Ausführungsform ist das Gesamtmodell mittels einer graphischen Programmiersprache wie z.B. Simulink® von der Firma The MathWorks Inc. implementiert.

Abbildung 4 zeigt die Struktur des Differenzenmodells. Es ist in zwei Teilmodelle aufgeteilt. Ein erstes Teilmodell, in dem die Abweichungen berücksichtigt werden, die zu einer im Vergleich mit der Referenzzelle unterschiedlichen EMK mindestens einer weiteren Einzelzelle führen, und eine zweites Teilmodell, mit dem die Abweichungen von Größen der weiteren Einzelzellen berücksichtigt werden, die in Bezug auf die Referenzzelle einen Unterschied in den Überspannungen der weiteren Einzelzellen zur Folge haben.

Das erste Teilmodell ermittelt aus den Anfangsladezuständen $SOC_0$, den Nennkapazitäten $C_{\text{Nenn}}$ und den Klemmenströmen der weiteren Einzelzellen des Zellenverbundes (wobei sich der Klemmenstrom einer weiteren Einzelzelle aus dem Klemmenstrom der Referenzzelle $i_{\text{Kl}}$ und der dem vorgegebenen Differenz-Klemmenstrom $\Delta i_{\text{Kl}}$ der weiteren Einzelzelle zusammensetzt) die Differenz der EMK ($\Delta$EMK) der weiteren Einzelzellen bezüglich der EMK der Referenzzelle. Anfangsladezustand $SOC_0$ und Nennkapazität $C_{\text{Nenn}}$ sind hierbei in einer bevorzugten Ausführungsform für alle Zellen jeweils durch einen gemeinsamen Wert gegeben. Je nachdem wie die EMK approximiert wird, können noch weitere Simulationsgrößen oder Parameter übergeben werden, z.B. der Ladungszustand der Referenzzelle $SOC_{\text{Ref}}$.

Zunächst wird nach Gleichung 1 der SOC jeder weiteren Einzelzelle aus einem vorgegebenen Anfangsladezustand und durch Integration des Klemmenstromes der jeweiligen weiteren Einzelzelle bestimmt.

Danach wird festgestellt, in welchem Bereich der EMK(SOC)-Kurve sich die Referenzzelle und die jeweiligen weiteren Einzelzellen des Zellenverbundes befinden, um dann beispielsweise aus einem approximierten EMK-SOC-Zusammenhang die EMK der Referenzzelle und der weiteren Einzelzellen zu bestimmen. Eine Approximation kann durchgeführt werden, wenn der Zusammenhang dem Modell nicht in einer Tabelle hinterlegt ist.

Im zweiten Teilmodell des Differenzenmodells werden Abweichungen bezüglich der Klemmspannung der Referenzzelle bestimmt, die sich als Folge von Unterschieden in den Klemmenströmen $\Delta i_{\text{Kl}}$ der jeweiligen weiteren Einzelzellen und den ohmschen Widerständen $\Delta R_{\text{innen}}$ ergeben. Unterschiede in den Klemmenströmen in den weiteren Einzelzellen können durch unterschiedlich hohe Verlustströme oder durch Eingriffe des BMS auftreten. Unterschiede des Innenwiderstandes $R_{\text{innen}}$ zwischen den Einzelzellen der Batterie können auf Streuungen in der Produktion oder unterschiedliche Zelltemperaturen zurückgeführt werden. Die zu betrachtende Abweichung $\Delta u_{\text{innen}}$ einer weiteren Einzelzelle bezüglich der Überspannung $u_{\text{innen}}$ der Referenzzelle ergibt sich somit nach Gleichung 2:

$$\Delta u_{innen} = \Delta R_{innen}\, i_{Kl} + \Delta R_{innen} \Delta i_{Kl} + R_{innen}\Delta i_{Kl}$$

(Gleichung 2)

Das zweite Teilmodell erhält vom Referenzmodell die Zellentemperatur $T_{\text{Ref}}$, den ohmschen Innenwiderstand $R_{\text{innen Ref}}$ und den Klemmenstrom $i_{\text{Kl}}$ der Referenzzelle. Die Unterschiede dieser Größen ($\Delta R_{\text{innen}}$, $\Delta T$, $\Delta i_{\text{Kl}}$) der weiteren Einzelzellen des Zellenverbundes von denen der Referenzzelle werden bevorzugt von außen vorgegeben.

Der Widerstandsanteil setzt sich aus zwei Teilen zusammen:

$$\Delta R_{innen} = \Delta R_{\text{innen}}(T) + \Delta R_0 \qquad \text{(Gleichung 3)}$$

Der Widerstand $\Delta R_0$ beschreibt die Differenz des Widerstands $R_{\text{innen}}$ der Referenzzelle zu dem einer weiteren Einzelzelle, die aufgrund der Herstellungsprozesse auftreten können. $\Delta R(T)$ wiederum modelliert Widerstandsdifferenzen die sich durch die Temperaturabhängigkeit des ohmschen Innenwiderstands aus Temperaturunterschieden zwischen der Referenzzelle und einer weiteren Einzelzelle des Zellenverbundes ergeben.
Der Wert $\Delta R(T)$ wiederum kann auf dieselbe Art bestimmt werden, wie der $\Delta$EMK-Wert im ersten Teilmodell. Beispielsweise können im Modell für die Referenzzelle beide Werte über Tabellen bestimmt werden. Anhand der Temperatur der Referenzzelle und der weiteren Einzelzelle, die sich aus der Summe der Referenzzellentemperatur und der Differenz $\Delta T$ ergibt, wird bestimmt, in welchem Bereich der Innenwiderstand-Temperaturkennlinie sich die Referenzzelle und die weitere Einzelzelle befinden. Der Innenwiderstand der Referenzzelle und der weiteren Einzelzelle kann aus einer approximierten Innenwiderstands-Temperaturkennlinie bestimmt werden.

Die Approximation kann beispielsweise wie auch bei der Approximation der EMK bereichsweise mittels Geraden-Gleichungen erfolgen oder indem die Steigung vorgegeben und dann linear interpoliert wird.

Im zweiten Teilmodell können Unterschiede in den Parametern $R_{\text{DS}}$ und $R_{\text{Diff}}$ über $\Delta R_0$ betrachtet werden. $R_{\text{Diff}}$ bezeichnet hierbei den Widerstand des zweiten RC-Gliedes aus dem Ersatzschaltbild, mit dem Diffusionsvorgängen Rechnung getragen wird. Es ist zu beachten, dass die Unterschiede der Klemmspannungen, die auf Abweichungen der Werte für $R_{\text{DS}}$ und $R_{\text{Diff}}$ zurückzuführen sind, sofort anliegen und nicht erst nach der Einschwingzeit der RC-Glieder in dem Einzelzellenmodell.

Ein Vorteil des Differenzenmodells ist, dass je nach Detailgrad, mit dem ein Zellenverbund mit dem Gesamtmodell simuliert werden soll, weitere Teilmodelle dem Differenzenmodell hinzugefügt oder aus dem Differenzenmodell entfernt werden können, ohne Einfluss auf andere Teile des Differenzenmodells zu haben. Je detaillierter die Simulation des Zellenverbundes sein soll, desto mehr Modellteile des ersten Modells werden in das Differenzenmodell eingefügt.

So wird in einer Ausführungsform der Erfindung die Temperatur einer weiteren Einzelzelle im Zellenverbund bei der Batteriesimulation mit dem Gesamtmodell von dem ersten Modell übernommen. Die weitere Einzelzelle im Zellenverbund, die am Anfang des simulierten Zeitraums eine Temperaturdifferenz $\Delta T$ bezüglich der Referenzzelle aufweist, weist somit während des gesamten simulierten Zeitbereichs diese Temperaturdifferenz auf. Dies entspricht aber nicht der Realität, bzw. der Simulation mit dem Einzelzellenmodell, da die von einer Einzelzelle abgestrahlte Wärmeleistung bei höherer Zellentemperatur größer ist. Die höhere Abstrahlung der Wärmeleistung wird durch eine konstante Temperaturdifferenz $\Delta T$ nicht berücksichtigt, wenn die Temperatur der Referenzzelle bei der Simulation der Einzelzellen des Zellenverbundes herangezogen wird. Sollen solche Temperatureffekte bei der Simulation eines Zellenverbundes mit betrachtet werden, so wird in einer anderen Ausführungsform der Erfindung das Differenzenmodell zur Bestimmung der jeweiligen Temperatur für die weiteren Einzelzellen (bzw. der Abweichung der Temperatur von der Temperatur der Referenzzelle) um ein Temperaturmodell, d.h. ein weiteres Teilmodell, einer Einzelzelle erweitert (analog zu dem ersten Teilmodell zur Bestimmung der Abweichung der EMK oder dem zweiten Teilmodell zur Bestimmung der Abweichung der Überspannung).

Mit dem Gesamtmodell werden in einer Ausführungsform explizit in Serie geschaltete Batteriezellen simuliert.

In einer weiteren Ausführungsform werden parallel geschaltete Zellen simuliert, indem die Parallelschaltung der Einzelzellen zu einer Einzelzelle mit einer entsprechend höheren Kapazität zusammengefasst wird.

Die Spannungsabweichung jeder weiteren Einzelzelle von der Klemmspannung der Referenzzelle wird berechnet durch die Summation der für die weiteren Einzelzellen in den einzelnen Teilmodellen des Differenzenmodells berechneten Spannungsabweichungen. Weiterhin werden in einer weiteren Ausführungsform Spannungsabweichungen aufgrund zusätzlicher äußerer Zellenströme der weiteren Einzelzellen berücksichtigt. In einer weiteren Ausführungsform werden Induktivitäten der weiteren Einzelzellen sowie thermische Verluste berücksichtigt.

**Patentansprüche**

1. Verfahren zur Echtzeit-Simulation einer einen Zellenverbund aus mehreren Einzelzellen umfassenden Batterie mittels eines Gesamtmodells,
   wobei ein Echzeitrechner über einen Zellspannungsemulator mit einem Steuergerätesystem verbunden ist, wobei mittels des Gesamtmodells die Klemmspannungen der Einzelzellen auf dem Echtzeitrechner berechnet werden, wobei mittels des Zellspannungsemulators dem Steuergerätesystem die berechneten Klemmspannungen der Einzelzellen zur Verfügung gestellt werden, und wobei das Gesamtmodell ein erstes Modell, mittels dessen eine erste Einzelzelle als Referenzzelle mit für den Zellenverbund typischen Zellparametern modelliert wird, und ein zweites Modell umfasst;

mit den Schritten:

dem ersten Modell wird als Eingangsgröße der Gesamteingangsstrom des Zellenverbundes zugeführt, mittels des ersten Modells wird die Klemmspannung der Referenzzelle und mindestens eine weitere Größe der Referenzzelle, insbesondere Ladungszustand, Temperatur oder Innenwiderstand berechnet, mittels des zweiten Modells wird eine Abweichung der Klemmspannung mindestens einer weiteren Einzelzelle von der Klemmspannung der Referenzzelle berechnet, wobei zur Berechnung der Abweichung der Klemmspannung der weiteren Einzelzelle gegenüber der Klemmspannung der Referenzzelle dem zweiten Modell mindestens eine Abweichung der weiteren Einzelzelle bezüglich der Größe gegenüber der Referenzzelle vorgegeben wird und wobei zur Verringerung der Rechenzeit die Größe für die weitere Einzelzelle aus der für die Referenzzelle mittels des ersten Modells berechneten Größe und der vorgegebenen Abweichung der entsprechenden Größe für die weitere Einzelzelle bezüglich der Referenzzelle bestimmt wird, sodass die Größe nicht für jede Einzelzelle gesondert simuliert wird, und

die Klemmspannung der weiteren Einzelzelle wird aus der Klemmspannung der Referenzzelle und der Abweichung der Klemmspannung der weiteren Einzelzelle berechnet.

2. Verfahren nach Anspruch 1, **dadurch gekennzeichnet, dass** die Abweichung der Klemmspannung jeder weiteren Einzelzelle von der Klemmspannung der Referenzzelle berechnet wird.

3. Verfahren nach Anspruch 1 oder 2, **dadurch gekennzeichnet, dass** die vorgegebene Abweichung der weiteren Einzelzelle bezüglich einer Größe oder eines Zellenparameters gegenüber der Referenzzelle eine Abweichung bezüglich des Widerstands, der Temperatur oder des Klemmstroms ist.

4. Verfahren nach einem der vorherigen Ansprüche, **dadurch gekennzeichnet, dass** die Zellentemperatur der weiteren Einzelzelle aus der für die Referenzzelle mittels des ersten Modells berechneten Zellentemperatur und der vorgegebenen Abweichung der Zellentemperatur für die weitere Einzelzelle bezüglich der Referenzzelle bestimmt wird.

5. Verfahren nach einem der vorherigen Ansprüche, **dadurch gekennzeichnet, dass** Eingangsgrößen dem zweiten Modell in vektorieller Form vorgegeben werden, wobei die Vektorlänge durch die Anzahl der berücksichtigten weiteren Einzelzellen bestimmt ist.

6. Verfahren nach einem der vorherigen Ansprüche, **dadurch gekennzeichnet, dass** das zweite Modell ein erstes Teilmodell aufweist, wobei mittels des ersten Teilmodells die Abweichung der elektromotorischen Kraft der weiteren Einzelzelle bezüglich der Referenzzelle berechnet wird, und/oder dass das zweite Modell ein zweites Teilmodell aufweist, wobei mittels des zweiten Teilmodells die Abweichung der Überspannung der weiteren Einzelzelle bezüglich der Überspannung der Referenzzelle berechnet wird.

7. Verfahren nach Anspruch 6, **dadurch gekennzeichnet, dass** zur Erhöhung der Genauigkeit der Simulation dem zweiten Modell mindestens ein weiteres Teilmodell zur Simulation einer weiteren Größe bezüglich der mindestens einen weiteren Einzelzelle hinzugefügt wird.

8. Verfahren nach Anspruch 6 oder 7, **dadurch gekennzeichnet, dass** aus dem zweiten Modell ein Teilmodell entfernt wird, wobei bei der Simulation der Batterie durch das Gesamtmodell die in dem entfernten Teilmodell durch Simulation bestimmte Größe durch den entsprechenden Wert der Größe für die Referenzzelle und eine vorgegebene entsprechende Abweichung des Wertes für die weitere Einzelzelle berücksichtigt wird.

9. Verfahren nach einem der vorherigen Ansprüche, **dadurch gekennzeichnet, dass** wenigstens eine Größe tabellarisch hinterlegt oder approximiert wird.

10. Verfahren nach einem der vorherigen Ansprüche, **dadurch gekennzeichnet, dass** die Zusammenschaltung der Einzelzellen der Batterie als Serienschaltung simuliert wird.

11. Verfahren nach einem der vorherigen Ansprüche, **dadurch gekennzeichnet, dass** die Zusammenschaltung der Einzelzellen der Batterie als Parallelschaltung simuliert wird, indem mehrere parallelgeschaltete weitere Einzelzellen als eine weitere Einzelzelle mit entsprechend höherer Kapazität modelliert werden.

12. System zur Simulation einer einen Zellenverbund aus mehreren Einzelzellen umfassenden Batterie mittels eines Gesamtmodells, aufweisend einen Echtzeitrechner und einen mit dem Echtzeitrechner verbundenen Zellspannungsemulator, wobei der Echtzeitrechner eingerichtet ist, das Gesamtmodell zur Berechnung der Klemmspannungen der Einzelzellen auszuführen, wobei der Zellspannungsemulator ausgebildet ist, mit einem Steuergerätesystem verbunden zu werden und dem Steuergerätesystem die berechneten Klemmspannungen der Einzelzellen zur Verfügung zu stellen, wobei das Gesamtmodell ein erstes Modell umfasst, wobei das erste Modell eingerichtet ist, eine erste Einzelzelle als Referenzzelle mit typischen Zellenparametern zu modellieren, den Gesamteingangsstrom des Zellenverbundes als Eingangsgröße zu erhalten und die Klemmspannung der Referenzzelle und mindestens eine weitere Größe der Referenzzelle, insbesondere Ladungszustand, Temperatur oder Innenwiderstand, zu berechnen, und wobei das Gesamtmodell ein zweites Modell umfasst, wobei das zweite Modell eingerichtet ist, die Abweichung der Klemmspannung mindestens einer weiteren Einzelzelle von der Klemmspannung der Referenzzelle zu berechnen, wobei zur Berechnung der Abweichung der Klemmspannung der weiteren Einzelzelle gegenüber der Klemmspannung der Referenzzelle dem zweiten Modell mindestens eine Abweichung der weiteren Einzelzelle bezüglich der Größe gegenüber der Referenzzelle vorgebbar ist und wobei zur Verringerung der Rechenzeit die Größe für die weitere Einzelzelle aus der für die Referenzzelle mittels des ersten Modells berechneten Größe und der vorgegebenen Abweichung der entsprechenden Größe für die weitere Einzelzelle bezüglich der Referenzzelle bestimmbar ist, sodass die Größe nicht für jede Einzelzelle gesondert simuliert wird, und wobei das Gesamtmodell eingerichtet ist, die Klemmspannungen der weiteren Einzelzelle aus der Abweichung und der Klemmspannung der Referenzzelle zu berechnen.

13. System zur Simulation einer einen Zellenverbund aus mehreren Einzelzellen umfassenden Batterie nach Anspruch 12, **dadurch gekennzeichnet, dass** mit dem System das Verfahren nach einem der Ansprüche 2 bis 11 durchführbar ist.

## Claims

1. A method for simulating in real time, by means of an overall model, a battery comprising a cell composite made of a plurality of individual cells, a real-time processor being connected to a control device system via a cell voltage emulator, the terminal voltages of the individual cells being calculated on the real-time processor by means of the overall model, the calculated terminal voltages of the individual cells being made available to the control device system by means of the cell voltage emulator, and the overall model comprising a first model, by means of-which a first individual cell is modeled using cell parameters typical for the cell composite, and a second model, comprising the steps:

   feeding the overall input current of the cell composite to the first model as an input parameter calculating the terminal voltage of the reference cell and at least one further parameter of the reference cell, particularly the charge state, temperature, or
   internal resistance, by means of the first model,
   calculating a deviation of the terminal voltage of at least one further individual cell from the terminal voltage of the reference cell by means of the second model, at least one deviation of the further individual cell with respect to the parameter relative to the reference cell being specified to the second model for calculating the deviation of the terminal voltage of the further individual cell relative to the terminal voltage of the reference cell, and the parameter for the further individual cell being determined from the parameter calculated by means of the first model and the specified deviation of the corresponding parameter for the further individual cell relative to the reference cell, in order to reduce the calculation time, so that the parameter is not simulated separately for each individual cell, and
   the terminal voltage of the further individual cell is calculated from the terminal voltage of the reference cell and the deviation of the terminal voltage of the further individual cell.

2. The method according to claim 1, **characterized in that** the deviation of the terminal voltage of each further individual cell is calculated from the terminal voltage of the reference cell.

3. The method according to claim 1 or 2, **characterized in that** the specified deviation of the further individual cells with respect to a parameter or a cell parameter relative to the reference cell is a deviation with respect to the resistance, the temperature, or the terminal current.

4. The method according to any one of the preceding claims, **characterized in that** the cell temperature of the further individual cells is determined from the cell temperature calculated for the reference cell by means of the first model and from the specified deviation of the cell temperature for the further individual cells with respect to the reference cell.

5. The method according to any one of the preceding claims, **characterized in that** input parameters are specified to the second model in vectorial form, wherein the vector length is determined by the quantity of further individual cells considered.

6. The method according to any one of the preceding claims, **characterized in that** the second model comprises a first partial model, wherein the deviation of the electromotive force of the further individual cell with respect to the reference cell is calculated by means of the first partial model, and/or that the second model comprises a second partial model, Wherein the deviation of the overvoltage of the further individual cell with respect to the overvoltage of the reference cell is calculated by means of the second partial model.

7. The method according to claim 6, **characterized in that** at least one further partial model for simulating a further parameter with respect to the at least one further individual cell is added to the second model for increasing the accuracy of the simulation.

8. The method according to claim 6 or 7, **characterized in that** a partial model is removed from the second model, wherein the parameter determined by simulation in the removed partial model is accounted for by the corresponding value of the parameter for the reference cell and a specified corresponding deviation of the value for the further individual cell when the battery is simulated by the overall model.

9. The method according to any one of the preceding claims, **characterized in that**, at lea tone parameter is stored or approximated in tabular form.

10. The method according to any one of the preceding claims, **characterized in that** the circuit connecting the individual cells of the battery is simulated as a series circuit.

11. The method according to any one of the preceding claims, **characterized in that** the circuit connecting the individual cells of the battery is simulated as a parallel circuit, **in that** a plurality of further individual cells connected in parallel are modeled as a further individual cell having correspondingly higher capacity.

12. A system for simulating a battery comprising a cell composite made of a plurality of individual cells, comprising a real-time processor and a cell voltage emulator connected to the real-time processor, the real-time processor being set up for executing the overall model for calculating the terminal voltages of the individual cells, the cell voltage emulator being implemented for being connected to a control device system and providing the calculated terminal voltages of the individual cells to the control device system, the overall model comprising a first model, the first model being set up for modeling a first individual cell as a reference cell having typical cell parameters, for receiving the overall input current of the cell composite as an input parameter, and for calculating the terminal voltage of the reference cell and at least one further parameter of the reference cell, particularly the charge state, temperature, or internal resistance, and the overall model comprising a second model, the second model being set up for calculating the deviation of the terminal voltage of at least one further individual cell from the terminal voltage of the reference cell, at least one deviation of the further individual cell with respect to the parameter relative to the reference cell being able to be specified to the second model for calculating the deviation of the terminal voltage of the further individual cell relative to the terminal voltage of the reference cell, and the parameter for the further individual cell being able to be determined from the parameter calculated by means of the first model and the specified deviation of the corresponding parameter for the further individual cells relative to the reference cell, in order to reduce the calculation time, so that the parameter is not simulated separately for each individual cell, and the overall model being set up for calculating the terminal voltages of the further individual cell from the deviation and the terminal voltage of the reference cell.

13. The system for simulating a battery comprising a cell composite made of a plurality of individual cells according to claim 12, **characterized in that** the method according to any one of the claims 2 through 11 can be performed by means of the system.

**Revendications**

1. Procédé pour simuler en temps réel, à l'aide d'un modèle d'ensemble, une batterie regroupant un assemblage de cellules composé de plusieurs cellules individuelles,
dans lequel un calculateur en temps réel est relié avec un émulateur de tension de cellule via un système d'appareil de commande,
dans lequel les tensions aux bornes des cellules individuelles sont calculées sur le calculateur en temps-réel à l'aide du modèle d'ensemble,
dans lequel les tensions aux bornes calculées des cellules individuelles sont mises à la disposition du système d'appareil de commande à l'aide de l'émulateur de tension de cellule, et dans lequel
le modèle d'ensemble comprend un premier modèle à l'aide duquel une première cellule individuelle est modelée en tant que cellule de référence avec des paramètres de cellule typiques pour l'assemblage de cellules, et un second modèle ; comprenant les étapes suivantes :

le courant d'entrée global de l'assemblage de cellules est délivré au premier modèle en tant que grandeur d'entrée,
la tension aux bornes de la cellule de référence et au moins une grandeur supplémentaire de la cellule de référence, en particulier l'état de chargement, la température ou la résistance interne, sont calculées à l'aide du premier modèle,
à l'aide du second modèle, un écart de la tension aux bornes d'au moins une cellule individuelle supplémentaire par rapport à la tension aux bornes de la cellule de référence est calculé, sachant que pour le calcul de l'écart de la tension aux bornes de la cellule individuelle supplémentaire par rapport à la tension aux bornes de la cellule de référence, au moins un écart de la cellule individuelle supplémentaire pour la grandeur par rapport à la cellule de référence est alloué au second modèle et sachant que pour réduire le temps de calcul, la grandeur pour la cellule individuelle supplémentaire est déterminée à partir de la grandeur calculée pour la cellule de référence à l'aide du premier modèle et de l'écart alloué de la grandeur correspondante pour la cellule individuelle supplémentaire par rapport à la cellule de référence, de sorte que la grandeur ne soit pas simulée séparément pour chaque cellule individuelle, et
la tension aux bornes de la cellule individuelle supplémentaire est calculée à partir de la tension aux bornes de la cellule de référence et de l'écart de la tension aux bornes de la cellule individuelle supplémentaire.

2. Procédé selon la revendication 1, **caractérisé en ce que** l'écart de la tension aux bornes de chaque cellule individuelle supplémentaire est calculée à partir de la tension aux bornes de la cellule de référence.

3. Procédé selon la revendication 1 ou 2, **caractérisé en ce que** l'écart alloué de la cellule individuelle supplémentaire pour une grandeur ou un paramètre de cellule par rapport à la cellule de référence est un écart de la résistance, de la température ou du courant aux bornes.

4. Procédé selon l'une des revendications précédentes, **caractérisé en ce que** la température de cellule de la cellule individuelle supplémentaire est déterminée à partir de la température de cellule calculée pour la cellule de référence à l'aide du premier modèle et de l'écart alloué de température de cellule pour la cellule individuelle supplémentaire par rapport à la cellule de référence.

5. Procédé selon l'une des revendications précédentes, **caractérisé en ce que** des grandeurs d'entrée sont allouées sous forme vectorielle au second modèle, sachant que la longueur de vecteur est déterminée par le nombre des cellules individuelles supplémentaires prises en compte.

6. Procédé selon l'une des revendications précédentes, **caractérisé en ce que** le second modèle comporte un premier modèle partiel, sachant que l'écart de la force électromotrice de la cellule individuelle supplémentaire par rapport à la cellule de référence est calculé à l'aide du premier modèle partiel et/ou que le second modèle comporte un second modèle partiel, sachant que l'écart de la surtension de la cellule individuelle supplémentaire par rapport à la surtension de la cellule de référence est calculé à l'aide du second modèle partiel.

7. Procédé selon la revendication 6, **caractérisé en ce que** pour augmenter la précision de la simulation, au moins un modèle partiel supplémentaire est ajouté au second modèle pour simuler une grandeur supplémentaire par rapport à l'au moins une cellule individuelle supplémentaire.

8. Procédé selon la revendication 6 ou 7, **caractérisé en ce qu'**un modèle partiel est supprimé du second modèle, sachant que lors de la simulation de la batterie par le modèle d'ensemble, la grandeur déterminée par simulation dans le modèle partiel supprimé est prise en compte par la valeur correspondante de la grandeur pour la cellule de référence et un écart alloué correspondant de la valeur pour la cellule individuelle supplémentaire.

**9.** Procédé selon l'une des revendications précédentes, **caractérisé en ce qu'**une grandeur au moins est stockée ou approximée sous forme de tableau.

**10.** Procédé selon l'une des revendications précédentes, **caractérisé en ce que** l'interconnexion des cellules individuelles de la batterie est simulée en tant que couplage en série.

**11.** Procédé selon l'une des revendications précédentes, **caractérisé en ce que** l'interconnexion des cellules individuelles de la batterie est simulée en tant que couplage en parallèle en ce sens que plusieurs cellules individuelles supplémentaires couplées en parallèle sont modelées en tant qu'une cellule individuelle supplémentaire de capacité corrélativement plus élevée.

**12.** Système pour simuler en temps réel, à l'aide d'un modèle d'ensemble, une batterie regroupant un assemblage de cellules composé de plusieurs cellules individuelles, comportant un calculateur en temps réel, et un émulateur de tension de cellule relié avec le calculateur en temps réel, dans lequel le calculateur en temps-réel est configuré pour exécuter le modèle d'ensemble pour le calcul des tensions aux bornes des cellules individuelles, dans lequel l'émulateur de tension de cellule se présente sous une forme pour être relié avec un système d'appareil de commande et mettre à la disposition du système d'appareil de commande les tensions aux bornes calculées des cellules individuelles,
dans lequel
le modèle d'ensemble comporte un premier modèle, sachant que le premier modèle est configuré pour modeler une première cellule individuelle en tant que cellule de référence avec des paramètres de cellule typiques, recevoir le courant d'entrée global de l'assemblage de cellules en tant que grandeur d'entrée, et calculer la tension aux bornes de la cellule de référence et au moins une grandeur supplémentaire de la cellule de référence, en particulier l'état de chargement, la température ou la résistance intérieure, et dans lequel le modèle d'ensemble comporte un second modèle, sachant que le second modèle est configuré pour calculer l'écart de la tension aux bornes au moins d'une cellule individuelle supplémentaire par rapport à la tension aux bornes de la cellule de référence, sachant que pour le calcul de l'écart de la tension aux bornes de la cellule individuelle supplémentaire par rapport à la tension aux bornes de la cellule de référence, au moins un écart de la cellule individuelle supplémentaire pour la grandeur par rapport à la cellule de référence est allouable au second modèle et sachant que pour réduire le temps de calcul, la grandeur pour la cellule individuelle supplémentaire est déterminable à partir de la grandeur calculée pour la cellule de référence à l'aide du premier modèle et de l'écart alloué de la grandeur correspondante pour la cellule individuelle supplémentaire par rapport à la cellule de référence, de sorte que la grandeur ne soit pas simulée séparément pour chaque cellule individuelle, et sachant que le modèle d'ensemble est configuré pour calculer les tensions aux bornes de la cellule individuelle supplémentaire à partir de l'écart et de la tension aux bornes de la cellule de référence.

**13.** Système pour simuler une batterie regroupant un assemblage de cellules composé de plusieurs cellules individuelles selon la revendication 12, **caractérisé en ce que** le procédé selon l'une des revendications 2 à 11 peut être exécuté avec le système.

## Abbildung 1

## Abbildung 2

**Abbildung 3**

**Abbildung 4**